# EUROPEAN PATENT APPLICATION

(11) **EP 3 588 555 A1**
(43) Date of publication of application: **01.01.2020**
(21) Application number: 18180798.3
(22) Date of filing: 29.06.2018
(51) Int. Cl.: H01L 23/498, H05K 3/46

(54) **UNFOLDABLE LAYERED CONNECTION, AND METHOD FOR MANUFACTURING AN UNFOLDABLE LAYERED CONNECTION**

(71) Applicant: INL - International Iberian Nanotechnology Laboratory, 4715-330 Braga (PT)
(72) Inventor: Maria Alves Dias, Rosana, 4705-424 Celeirós, Braga (PT); Carlos Azevedo Gaspar, Joâo, 4715-330 Braga (PT)
(74) Representative: AWA Sweden AB

(57) **Abstract**

The present inventive concept relates to an unfoldable layered connection (700) comprising: a substrate (702); a node of connector material (716, 216) arranged to contact the substrate; a first extension (740) comprising a core (246) of connector material arranged to be in contact with the node (716, 216), and flexible material arranged to at least partially enclose the core (246); wherein the first extension (740) is configured to be hingedly connected to the node (716, 216), thereby allowing unfolding of the first extension (740) along a z-axis being perpendicular to an extension plane of a major surface of the substrate (702). The inventive concept further relates to a method for manufacturing an unfoldable layered connection.

## Description

### Technical field

The inventive concept described herein generally relates to the field of semiconductor device fabrication.

### Background

There has been a significant amount of research on connecting rigid integrated circuits to flexible interconnects. Several applications require placement of a device in locations that are hard to reach or benefit from flexible connections due to mechanical damage susceptibility. Examples include biomedical devices such as flexible neural interfaces, read-write magnetic heads, flexible displays, and lab-on-a-chip devices.

Some adopted solutions consist of relatively long flexible connections from the device to the outside environment. This may be achieved by fabrication of metal connections on flexible substrates. A relatively large area is often occupied by the connection structure compared to the device itself. Other solutions concern die attachment to flexible substrates, e.g. Chip-on-flex (COF) technologies. These technologies package individually diced chips in flexible substrates a *posteriori.*

There is a need for improved flexible connections with respect to at least manufacturing, packaging, and ease of use.

### Summary of the invention

It is an object of the present inventive concept to mitigate, alleviate or eliminate one or more of the above-identified deficiencies in the art and disadvantages singly or in combination.

According to a first aspect of the inventive concept, these and other objects are achieved in full, or at least in part, by a method for manufacturing an unfoldable layered connection on a substrate, the method comprising: providing a substrate with a first layer of sacrificial material; providing a first layer of flexible material over the substrate and the first layer of sacrificial material, thereby at least partially encapsulating the first layer of sacrificial material; providing an opening in the first layer of flexible material, thereby exposing at least a portion of the substrate; providing a first layer of connector material, being an uppermost layer of connector material, over the first layer of flexible material and the substrate, wherein the first layer of connector material is in contact with the substrate, thereby forming a first contact of connector material and a first node of connector material; providing a second layer of flexible material over the first layer of connector material, the second layer of flexible material being in contact with the first layer of flexible material, thereby at least partially encapsulating the first layer of connector material; optionally, exposing at least a portion of the uppermost layer of connector material, thereby forming a second contact of connector material; removing the first layer of sacrificial material, thereby creating a first void interface between the substrate and the first layer of flexible material, thereby forming a first extension across the first void interface being unfoldable along a z-axis being perpendicular to the substrate; wherein the first extension comprises at least part of the first and second layer of flexible material, and the at least partially encapsulated first layer of connector material.

To facilitate the overall description a coordinate system will be used, where the x- and y-axis extend in an extension plane of a major surface of the substrate, whereas the z-axis extends perpendicular to the extension plane of the substrate.

It will be understood, in the context of the present disclosure, that when a component, such as a layer, a film, a region, or a plate, is referred to as being "on" another component, the component may be directly on the other component or intervening components may be present thereon. In particular, it is to be understood that the void interfaces referred to in the present disclosure may serve the purpose of allowing the extensions that are formed to move in relation to the underlying layer(s), regardless of what specific layer(s) the void interface is actually separating. In other words, there may exist a void interface surrounding at least part of the extensions referred to in the present disclosure, thereby forming an extension being un foldable along the z-axis being perpendicular to the substrate.

The term 'providing' may in the context of the present disclosure comprise depositing, forming, and/or patterning. For example, in the case of 'providing a first layer of material', it is to be understood that the first layer of material may be deposited, formed, and/or patterned. In particular, a material may be formed and/or patterned during the process of depositing the material. The term 'providing' may also comprise material already being present when performing the method according to the inventive concept.

The term 'depositing' in the context of depositing layers of material should be interpreted broadly as to include any technique of forming a layer of material. In particular, the term 'depositing' may encompass spin coating, chemical vapor deposition, physical vapor deposition, sputtering, and similar techniques.

The term 'patterning' in the context of depositing material may comprise forming or patterning of the material via various techniques including photolithography, etching, lift-off, masking etc.

The term 'encapsulated' may be equivalently exchanged for the term 'enclosed' throughout the present disclosure.

Further, it will be understood that some parts of the processes in the present disclosure may be omitted for the sake of brevity. In particular, some steps of masking, patterning, or etching may be omitted since it is believed that the person skilled in the art understands from the present disclosure as a whole how these steps are to be carried out within the present inventive concept.

When materials such as 'flexible material', 'connector material', or sacrificial material' are being referred to, it is not necessarily one and the same type of material. The person skilled in the art realizes that it may be possible to use different types of e.g. flexible material in the unfoldable layered connection. In other words, different layers may comprise different types of e.g. flexible material, sacrificial material or connector material.

Further, it may be possible within the scope of the present inventive concept to provide several extensions having layers of flexible material and/or connector material of different thicknesses.

In general, the present inventive concept may reduce the surface footprint of a device having a flexible connection with respect to fabrication and the final device as such. The former may be achieved given the fact that the unfoldable flexible connection is primarily fabricated vertically with respect to the plane of the substrate. The latter may be achieved when manufacturing of several devices having respective unfoldable flexible connections is considered, since the present inventive concept allows for an increase in device density, and less space is required between devices. Some examples of devices benefitting from high density arraying are capacitive micromachined ultrasonic transducers (cMUTs), nanowire transistor arrays, and wide-range chemical and biological array-based screening.

Further, it is to be understood that an unfoldable layered connection according to the inventive concept may comprise several layers of extensions as described in the present disclosure. Additional extensions may be formed by repeating a set of the steps presented in the present disclosure, which will be readily understood by the person skilled in the art. Although some examples only incorporate one or two extensions, it is not to be understood as limiting the scope of the inventive concept.

The first contact of connector material may be in contact with the substrate, thus the unfoldable layered connection may provide routing and/or contact between the substrate and a device in communication with the second contact of connector material.

It is to be understood that the unfoldable layered connection may be arranged on any kind of substrate, and that the unfoldable layered connection may be completely released from the substrate e.g. via a sacrificial material and an etching step.

In the context of the present disclosure, the term 'meander shaped' should be understood to comprise bends, turns, windings, curves, annular shapes, right angles, acute angles, and obtuse angles. In particular, a meander shape may refer to a spiral shape. Further, it is to be understood that several extensions together may form a meander shape, although the individual extensions are straight. The meander shape may allow the unfoldable layered connection to go from a substantially two-dimensional extension into a three-dimensional extension during un-folding. An advantage with having a meander shaped first and/or second extension is that a longer unfoldable connection can be achieved without adding additional layers of extensions.

The first node of connector material may be, or comprise, the first contact of connector material.

The step of providing the opening in the first layer of sacrificial material may be performed by etching.

The first extension may be straight or meander shaped. The second extension may be straight or meander shaped. The first and second extension may together form a meander shape. It is to be understood that the first and second extensions may have different shapes.

The method may further comprise exposing the first extension by removing a portion of the first and second layer of flexible material, in order to allow the first extension to unfold along the z-axis. This may be advantageous if several unfoldable layered extensions are being manufactured in parallel on one and the same substrate.

The method may further comprise forming at least one access channel arranged to access the first layer of sacrificial material; wherein the step of providing the opening in the first layer of sacrificial material is performed by etching via the at least one access channel. The at least one access channel may be formed by removing a portion of the first and second layer of flexible material. Hereby, etching may be performed using etchants which must not necessarily be able to permeate through the flexible material. Further, etching speed and/or precision may be improved, even when utilizing etchants which are able to permeate or penetrate through the flexible material.

The method may comprise, after providing the second layer of flexible material, the steps of: providing a second layer of sacrificial material over the second layer of flexible material; providing a third layer of flexible material over the second layer of flexible material and the second layer of sacrificial material, thereby at least partially encapsulating the second layer of sacrificial material; providing a second opening in the second and third layer of flexible material, thereby exposing at least a portion of the first layer of connector material; providing a second layer of connector material thereby being the uppermost layer of connector material over the third layer of flexible material, wherein the second layer of connector material is in contact with the first layer of connector material thereby forming a second node of connector material; providing a fourth layer of flexible material over the second layer of connector material, the fourth layer of flexible material being in contact with the third layer of flexible material, thereby at least partially encapsulating the second layer of connector material; removing the second layer of sacrificial material thereby creating a second void interface between the second and third layer of flexible material, thereby forming a second extension across the second void interface being unfoldable along the z-axis; wherein the second extension comprises at least part of the third and fourth layer of flexible material, and the at least partially encapsulated second layer of connector material.

The removal of the first and second layer of sacrificial material, and any additional layer of sacrificial material, may be performed in a single step.

Hereby, a second extension may be formed over the first extension, the second extension having contact with the first extension via the second node of connector material. Additional extensions may be formed according to the steps above.

The method may further comprise exposing the second extension by removing a portion of the third and fourth layer of flexible material, in order to allow the first extension to unfold along the z-axis.

The at least one access channel may be arranged to access the first and second layer of sacrificial material, and wherein the step of providing the opening in the first and second layer of sacrificial material is performed by etching via the at least one access channel. The at least one access channel may be formed by removing a portion of the third and fourth layer of flexible material, in addition to removing a portion of the first and second layer of flexible material. Hereby, etching may be performed using etchants which must not necessarily be able to permeate through the flexible layers. Further, etching speed and/or precision may be improved.

The first and second nodes may be mutually displaced along the z-axis, and wherein the first and second nodes are connected via connector material. Hereby, a number of extensions of the unfoldable layered connection may be vertically stacked, thus reducing a surface footprint of the unfoldable layered connection.

The first and second nodes may be mutually displaced along an x-axis and/or a y-axis. Hereby, a meander shaped of the first and second extension may be achieved.

The first and second extension may form an angle with respect to each other in a plane being perpendicular to the z-axis. It is to be understood that the angle may be present at least when the unfoldable layered connection is folded, i.e. when the first and second extension are substantially parallel to the substrate.

The etchant may be HF. It is to be understood that other etchants may be used, such as acetone or any organic or inorganic solvent which may selectively etch the sacrificial material with respect to the flexible material and the connector material. The HF may be in the form of vapor and/or liquid.

The sacrificial material may be SiO₂. It is to be understood that other sacrificial materials may be used, such as photoresists, PMMA, or other materials for which there exist a solvent or etchant which selectively attacks the material with respect to the flexible material and the connector material.

The flexible material may be polyimide. It is to be understood that other flexible materials may be used, such other materials are preferably flexible materials which can be deposited and patterned and which are resistant to the solvent or etchants utilized to remove the sacrificial material. An advantage with using the above materials is that cured polyimide is permeable to HF, which may allow etching of SiO₂ without the need of access channels or release holes.

One combination of etchant, sacrificial material, flexible material and connecting material is HF, photoresist, PMMA and metal respectively.

As will be understood from the present disclosure, the flexible material may preferably be a flexible material being resistant to the etchant used to remove the sacrificial material. Further, the connector material may preferably be a connector material being resistant to the etchant used to remove the sacrificial material. Preferably, the flexible material is resistant and permeable to the etchant used; the connector material is resistant to the etchant used; and the sacrificial layer is attacked by the etchant.

The first and second layer of flexible material may have the same thickness. Further, if the unfoldable layered connection comprises a second extension, the third and fourth layer may have the same thickness. In general, the layers of flexible material which at least partially encapsulates the connector material in each respective extension may have the same thickness. Hereby, the connector material may be kept at a neutral axis of the extension, which may reduce stress on the connector material as the extension is flexed, i.e. when the unfoldable layered connection is un-folded. It is to be understood that the term 'the same thickness' should be interpreted broadly, and encompasses e.g. 'substantially the same thickness'.

The substrate may be silicon wafer or a printed circuit board.

The connector material may be an electrically conductive material. However, it may also be possible to manufacture an unfoldable layered connection according to the inventive concept comprising connector material pertaining to other communication techniques, such as light or heat. Consequently, the connector material may be configured to guide light signals, or to conduct heat. A material which conduct light signals should preferably have low optical loss, such as PMMA, EpoCore, or other transparent, flexible and/or ductile polymers. A flexible material in this regard could for example be EpoClad. It is also envisioned that the connecting material in a light signaling application may be flexible in itself, and comprise a thin reflective metal coating. The connector material may be AlSiCu or TiW.

The substrate may be a silicon wafer or a printed circuit board. The substrate may be a semiconductor substrate.

The method may further comprise the step of providing a base layer of flexible material over the substrate before the step of providing the first layer of sacrificial material over the substrate. As is readily understood, the first void interface referred to in the present disclosure will thus be created between the base layer of flexible material and the first layer of flexible material.

According to a second aspect of the inventive concept, these and other objects are achieved in full, or at least in part, by an unfoldable layered connection comprising: a substrate; a node of connector material arranged to contact the substrate; a first extension comprising a core of connector material arranged to be in contact with the node, and flexible material arranged to at least partially enclose the core; wherein the first extension is configured to be hingedly connected to the node, thereby allowing un-folding of the first extension along a z-axis being perpendicular to an extension plane of a major surface of the substrate.

The first extension may comprise at least two cores arranged to be in contact with the node, and wherein the flexible material is arranged to at least partially enclose each core. Hereby, an extension comprising two branches is achieved. The two branches may be separated so as to allow them to be moved independently from each other.

An extension may be divided into several separate branches, or sub-extensions, each functioning as a single extension and each having a core of connector material. Hereby, several unfoldable layered sub-connections may be achieved.

As described earlier in the present disclosure, the unfoldable layered connection may comprise at least one extension, such as two extensions or such as a plurality of extensions, wherein the extensions are layered one on top of the other and wherein the extensions are connected to each other via nodes of connector material.

Several unfoldable layered connections according to the inventive concept may be manufactured in parallel on one and the same substrate. The connections are subsequently divided in order to form several separate unfoldable layered connections. An advantage with the present inventive concept in this regard is that a high density of unfoldable layered connections can be achieved owing to the low surface footprint of the unfoldable layered connection according to the inventive concept.

According to a third aspect of the inventive concept, these and other objects are achieved in full, or at least in part, by a use of an unfoldable layered connection according to the second aspect on a silicon wafer or a printed circuit board.

The term 'hingedly connected' does not imply a structure resembling a hinge, but rather that the connection may achieve a rotation around a virtual axis. The term 'hingedly connected' may be exchanged for 'flexibly connected' or 'movably connected'.

A feature described in relation to one aspect may also be incorporated in other aspects, and the advantage of the feature is applicable to all aspects in which it is incorporated.

Other objectives, features and advantages of the present inventive concept will appear from the following detailed disclosure, from the attached claims as well as from the drawings.

Generally, all terms used in the claims are to be interpreted according to their ordinary meaning in the technical field, unless explicitly defined otherwise herein. Further, the use of terms "first", "second", and "third", and the like, herein do not denote any order, quantity, or importance, but rather are used to distinguish one element from another. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

### Brief description of the drawings

The above, as well as additional objects, features and advantages of the present inventive concept, will be better understood through the following illustrative and non-limiting detailed description of different embodiments of the present inventive concept, with reference to the appended drawings, wherein:
FIGS. 1a - 1q schematically illustrates a method for manufacturing an unfoldable layered connection according to one aspect of the inventive concept;
FIG. 2a schematically illustrates an example of an unfoldable layered connection;
FIG. 2b schematically illustrates a perspective view of an example of an unfoldable layered connection;
FIG. 2c schematically illustrates a perspective view of an example of an unfoldable layered connection;
FIG. 2d schematically illustrates a perspective view of an example of an unfoldable layered connection;
FIG. 3a schematically illustrates a top view of an unfoldable layered connection; and
FIG. 3b schematically illustrates a top view of an unfoldable layered connection.
FIG. 4a - 4c schematically illustrate several unfoldable layered connections manufactured on one and the same substrate;
FIGS. 5a - 5i schematically illustrate a method for manufacturing an unfoldable layered connection according to one aspect of the inventive concept.

### Detailed description

It may be repeated that some parts of the processes in the present disclosure may be omitted for the sake of brevity. In particular, some steps of masking, patterning, or etching may be omitted since it is believed that the person skilled in the art understands from the present disclosure as a whole how these steps are to be carried out within the present inventive concept. Some possible techniques which may be incorporated into the method described below include chemical vapor deposition (CVD), plasma etching, ashing, reactive ion etching (RIE), dry etching, inductively coupled plasma etching, lithography, and sputtering.

Further, it should be noted that the illustrated figures are not necessarily drawn to scale.

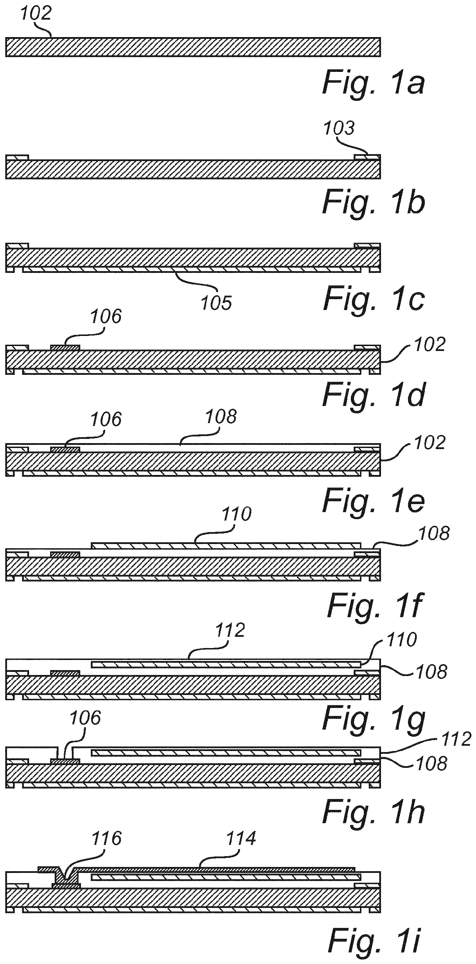

For the sake of clarity, it should also be noted that the disclosures made below in conjunction with FIGS. 1a - 1q comprise optional steps of depositing, patterning, forming, or providing layers of different materials, such as e.g. connector material and flexible material. For example, an optional base layer of flexible material is provided over the substrate before a step of depositing a first layer of sacrificial material over the substrate. Although such a base layer of flexible material is not necessarily needed and may be omitted, it may provide for that the substrate, and any other feature present on the substrate, is protected from e.g. an etchant used to subsequently remove the sacrificial layer. Further, optional steps of depositing a first layer of connector material and forming the first layer of connector material into a first contact of connector material are disclosed.

In the disclosures following below, the base layer of flexible material will be referred to as a first layer of flexible material. Subsequent layers of flexible material are numbered accordingly. In general, the terminology used, e.g. referring to a 'first', 'second', or 'third' layer, should not be interpreted as limiting the scope of the inventive concept, but merely as means for providing clarity in the following disclosure.

FIGS. 1a - 1q illustrates a method for manufacturing an unfoldable layered connection 100. It should be noted that although figures are denominated alphabetically, at least some steps disclosed in conjunction with the figures need not necessarily be performed in the specific order presented.

Referring first to FIG. 1a, a substrate 102 is provided. A first release layer 103 of sacrificial material is deposited over the substrate 102 as illustrated in step FIG. 1b. Further, a second release layer of sacrificial material 105 is deposited on the opposite side of the substrate 102 as illustrated in FIG. 1c.

Referring now to FIG. 1d, a first layer of connector material has been deposited over the substrate 102, and the first layer of connector material is formed into a first contact of connector material 106. Other features may also be formed of the first layer of connector material over the substrate 102.

Referring now to step FIG. 1e, a first layer of flexible material 108 is deposited over the substrate 102. The first layer of flexible material 108 may cover the first contact of connector material 106.

Referring now to step FIG. 1f, a first layer of sacrificial material 110 is deposited onto the first layer of flexible material 108. The first layer of sacrificial material 110, and in particular a patterning of the first layer of sacrificial material 110, may determine the shape or form of the released first extension. In other words, the first layer of sacrificial material 110 will, when removed, become a void interface between the surfaces between which the first layer of sacrificial material 110 was arranged. Thus, a pattern, shape or form of the first layer of sacrificial material 110 may indirectly determine a pattern, shape or form of the first extension referred to below. It is to be understood that some portions of flexible material may be necessary to remove in order to allow the first extension to unfold, in addition to removing the first layer of sacrificial material 110. Consequently, for the sake of clarity it should be noted that the first layer of sacrificial material 110 may be patterned and/or formed.

Referring now to FIG. 1g, a second layer of flexible material 112 is deposited onto the first layer of flexible material 108 and the first layer of sacrificial material 110. The first layer of sacrificial material 110 may be at least partially encapsulated by the second layer of flexible material 112. Further, the first contact of connector material may be at least partially encapsulated by the second layer of flexible material 112. In particular, the first layer of sacrificial material 110 may be encapsulated by the second layer of flexible material 112, and/or the first contact of connector material may be encapsulated by the second layer of flexible material 112.

Referring now to step FIG. 1h, a portion of the first and second layer of flexible material 108, 112 is removed. The removal of the portion of the first and second layer of flexible material 108, 112 may be performed by etching. The first contact of connector material 106 may thus be exposed. It is also envisioned that the first layer of connector material, and thus the first contact of connector material, may be deposited and formed e.g. after the step disclosed in conjunction with FIG. 1g instead of in the step disclosed in conjunction with FIG. 1d.

Referring now to FIG. 1i, a second layer of connector material 114 is deposited onto the second layer of flexible material 112. The second layer of connector material 114 is here an uppermost layer of connector material. The second layer of connector material 114 is in contact with the first layer of connector material 106 thereby forming a first node of connector material 116. The second layer of connector material 114 may be patterned to conform to a patterning of the first layer of sacrificial material 110. In other words, the second layer of connector material 114 may have a similar shape as the first layer of sacrificial material 110.

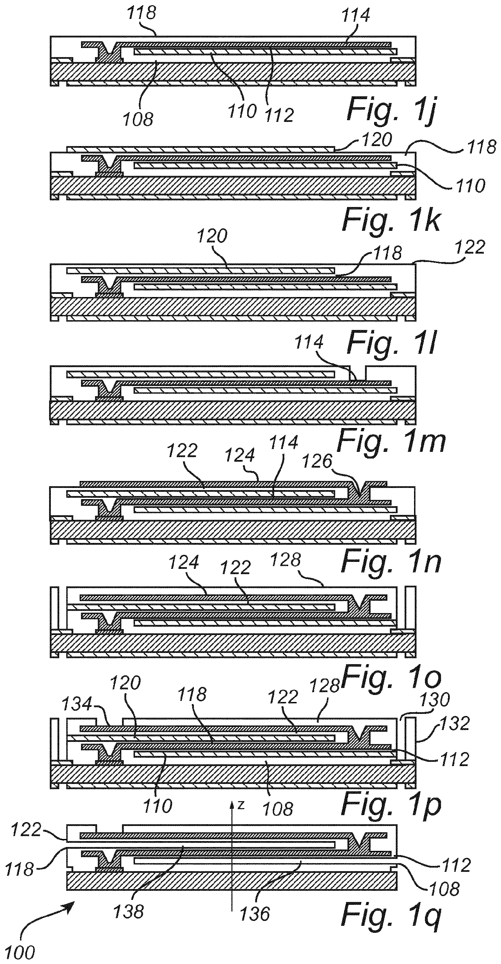

Referring now to FIG. 1j, a third layer of flexible material 118 is deposited onto the second layer of connector material 114. The third layer of flexible material 118 is in contact with the second layer of flexible material 112, thereby at least partially encapsulating the second layer of connector material 114. At this point, at least a portion of the uppermost layer of connector material may be exposed, thereby forming a second contact of connector material. The first layer of sacrificial material 110 may also be removed in order to create a first void interface between the first and second layer of flexible material 108, 112, thereby forming a first extension across the first void interface. However, in the illustrated example, a second level, i.e. a second extension is formed.

Referring now to FIG. 1k, a second layer of sacrificial material 120 is deposited onto the third layer of flexible material 118. Similarly to the first layer of sacrificial material 110, the second layer of sacrificial material 120, and in particular a patterning of the second layer of sacrificial material 120, may determine the shape or form of the released second extension. In other words, the second layer of sacrificial material 120 will, when removed, become a void interface between the surfaces between which the second layer of sacrificial material 120 was arranged. Thus, a pattern, shape or form of the second layer of sacrificial material 120 may indirectly determine a pattern, shape or form of the second extension referred to below. It is to be understood that some portions of flexible material may be necessary to remove in order to allow the first extension to unfold, in addition to removing the second layer of sacrificial material 120.

Referring now to FIG. 1l, a fourth layer of flexible material 122 is deposited onto the third layer of flexible material 118 and the second layer of sacrificial material 120, thereby at least partially encapsulating the second layer of sacrificial material 120.

Referring now to FIG. 1m, at least a portion of the second layer of connector material 114 is exposed. The exposing of at least the portion of the second layer of connector material 114 may be performed by etching. By exposing at least a portion of the second layer of connector material 114, a second contact of connector material may be formed. However, it is to be understood that in case more than one flexible extension is to be manufactured, e.g. two or more flexible extensions, one on top of the other, the exposing of the second layer of connector material 114 forms a second contact of connector material configured to connect the first and second flexible extensions.

Referring now to FIG. 1n, a third layer of connector material 124 is deposited, thereby being the uppermost layer of connector material, onto the fourth layer of flexible material 122, wherein the third layer of connector material 124 is in contact with the second layer of connector material 114 thereby forming a second node of connector material 126.

Referring now to step FIG. 1o, a fifth layer of flexible material 128 is deposited onto the third layer of connector material 124, the fifth layer of flexible material 128 being in contact with the fourth layer of flexible material 122 thereby at least partially encapsulating the third layer of connector material 124.

Referring now to FIG. 1p, a portion of flexible material is removed in order to at least partially expose the first and second extensions. A portion of the first, second, third, fourth, and fifth layer of flexible material 108, 112, 118, 122, 128 is removed. In particular, this may allow the unfoldable layered connection to be laid bare from neighboring unfoldable layered connections 132 manufactured on the same substrate. The removal of flexible material may also provide for that a first extension and second extension will be released, as described in the step disclosed in conjunction with FIG. 1 q below, when the first and second layer of sacrificial material 110, 120 is removed. It should be noted that the illustrated example only shows a two-dimensional representation of the inventive concept. In particular, a portion of flexible material may be removed also in a plane not shown in the illustrated example. Further, the removal of flexible material may also form an access channel 130 arranged to access sacrificial material, e.g. the first layer of sacrificial material 110 and the second layer of sacrificial material 120. Also illustrated in FIG. 1p is the exposing of at least a portion of the uppermost layer of connector material, thereby forming a second contact of connector material 134.

Referring now to FIG. 1q, the first and second layer of sacrificial material are removed thereby creating the first void interface 136 between the first and second layer of flexible material 108, 112, thereby forming a first extension across the first void interface 136 being unfoldable along a z-axis. Further, a second void interface 138 between the third and fourth layer of flexible material 118, 122 is created, thereby forming a second extension across the second void interface 138 being unfoldable along the z-axis. Optionally, as illustrated in FIG. 1q, the substrate may be divided in order to separate the unfoldable layered connection 100 from neighboring unfoldable layered connections. The first and second release layers of sacrificial material 103, 105 referred to in conjunction with FIG. 1b and 1c may facilitate such a division.

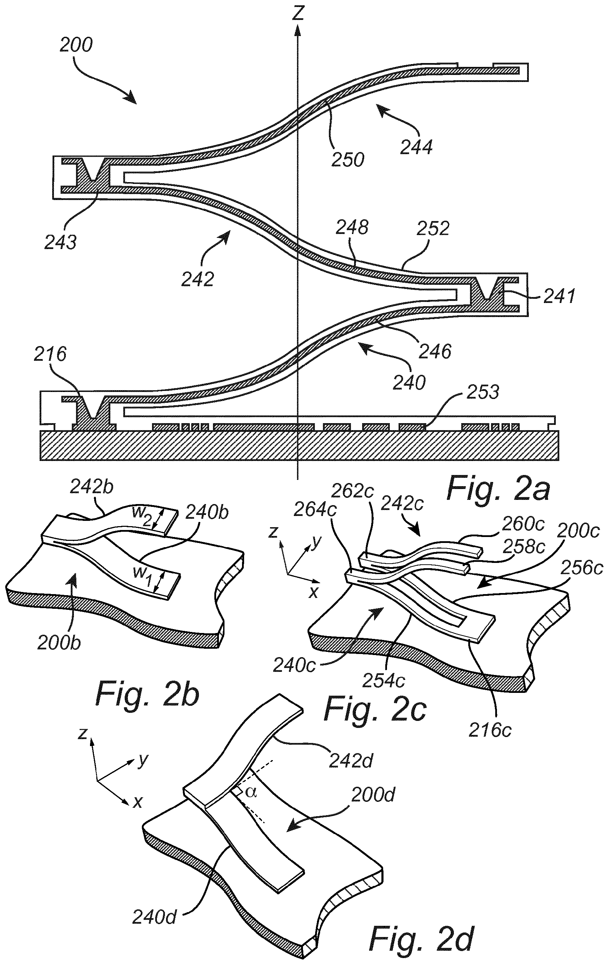

Referring now to FIG. 2a, an unfoldable layered connection 200 is illustrated. The unfoldable layered connection 200 here comprises a first extension 240, a second extension 242 and a third extension 244, i.e. three levels of extensions. The first extension 240 is configured to be connected to the substrate via a first node of connector material 216. The second extension 242 is connected to the first extension 240 via a second node of connector material 241. The third extension 244 is connected to the second extension 242 via a third node of connector material 243. As can be seen, the extensions are unfoldable along the z-axis. Further, the first, second and third node of connector material 216, 241, 243 are mutually displaced along the z-axis. Each of the extensions may comprise a respective core of connector material 246, 248, 250, at least partially enclosed by flexible material 252. The un-folding is made along the void interfaces 136, 138 that are formed during the manufacturing of the layered connection 200, see especially step (q) in FIG. 1. Further, as can be seen, various structures 253 may be arranged over the substrate.

Referring now to FIG. 2b, an unfoldable layered connection 200b is schematically illustrated in a perspective view. The illustration has been purposely simplified in order to more clearly convey the features discussed below. The unfoldable layered connection 200b here comprises a first extension 240b and a second extension 242b. The first extension 240b has a width W1 along the y-axis. The second extension 242b has a width W2 along the y-axis. The widths W1 and W2 are not necessarily equal. Further, it is to be understood that the width may vary over the length of a single extension.

Referring now to FIG. 2c, an unfoldable layered connection 200c is schematically illustrated in a perspective view. The illustration has been purposely simplified in order to more clearly convey the features discussed below. Here, a first extension 240c comprises two sub-extensions 254c, 256c. Each sub-extension may comprise a core in contact with a first node 216c of the unfoldable layered connection 200c, and flexible material may be arranged to at least partially enclose each core of the respective sub-extension. Similarly, a second extension 242c comprises two sub-extensions 258c, 260c. Each sub-extension of the second extension 242c may comprise a core in contact with a respective second node 262c, 264c. The sub-extensions 254c, 256c, 258c, 260c need not necessarily be the same length as in the illustrated example.

Referring now to FIG. 2d, an unfoldable layered connection 200d is schematically illustrated in a perspective view. The illustration has been purposely simplified in order to more clearly convey the features discussed below. Here, a first extension 240d and a second extension 242d are illustrated. The second extension 242d form an angle α with respect to each other in a plane being perpendicular to the z-axis, e.g. the xy-plane.

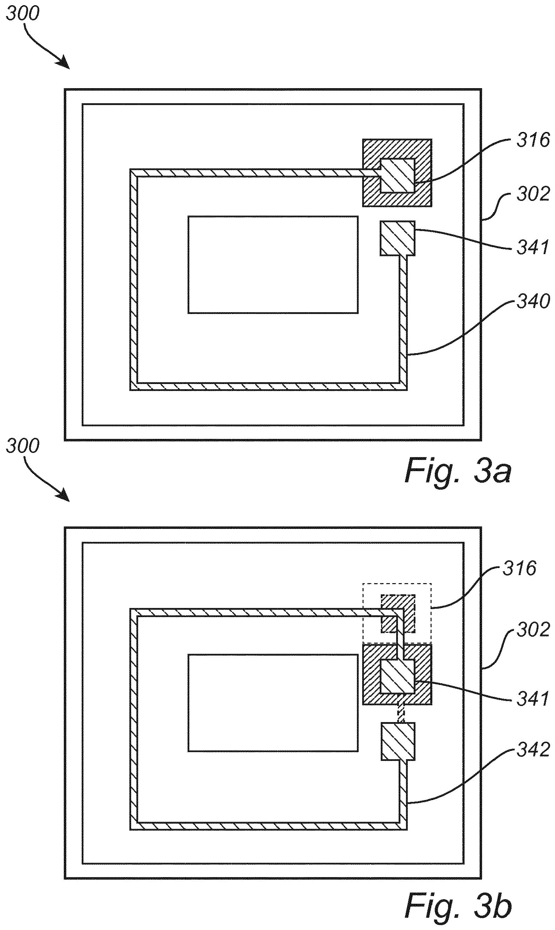

Referring now to FIG. 3a, a top view of an unfoldable layered connection 300 is illustrated. A first extension 340 is connected to a substrate 302 via a first node of connector material 316. The first extension 340 has a meander shape. The first extension 340 may comprise a core of connector material at least partially enclosed by flexible material. The illustrated shape of the first extension 340 may be referred to as a spiral shape. The meander shape of the first extension 340 allows the first extension 340 to be longer without occupying a significant surface area in a single particular direction. Also seen in this figure is the second node of connector material 341.

Referring now to FIG. 3b, a top view of the unfoldable layered connection 300 on a substrate 302 is illustrated. A second extension 342 is connected to the first extension referred to in conjunction with FIG. 3a via a second node of connector material 341. The second extension 342 may comprise a core of connector material at least partially enclosed by flexible material. The second extension 342 is meander shaped, which may be referred to as a spiral shape. Thus, the second extension 342 continues the spiral shape of the first extension, providing a surface efficient extension which is configured to be unfoldable. As is readily understood from FIGS. 3a and 3b, an unfoldable layered connection having at least two extensions being meander shaped, may be formed by a straight first extension and a straight second extension, wherein the second extension extend in a direction being different from a direction in which the first extension extends.

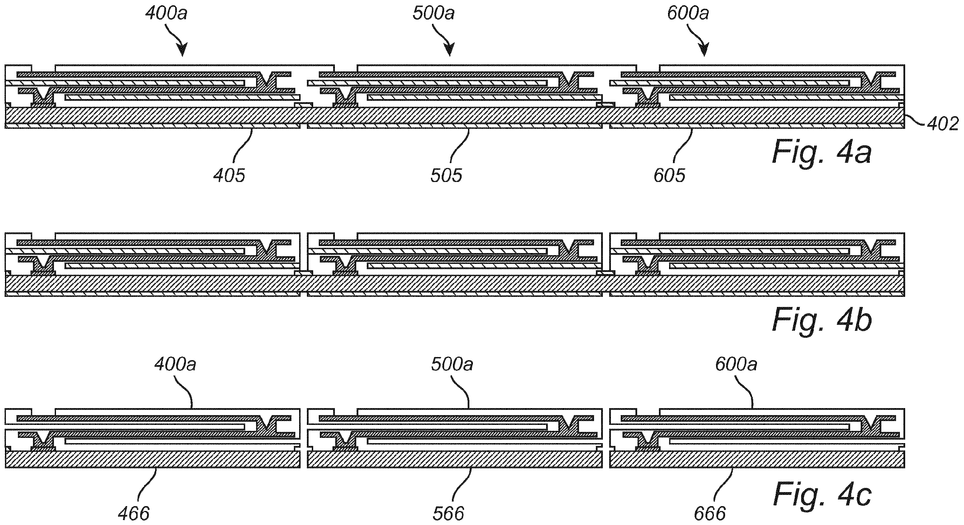

Referring now to FIG. 4a - 4c, several unfoldable layered connections manufactured on one and the same substrate are schematically illustrated. Here, a first unfoldable layered connection 400a, a second unfoldable layered connection 500a, and a third unfoldable layered connection 600a are shown. The unfoldable layered connections 400a, 500a, 600a have been manufactured, preferably in parallel, on one and the same substrate 402. Also shown is a respective second release layer 405, 505, 605. Referring now to FIG. 4b, a portion of flexible material has been removed from each of the unfoldable layered connections 400a, 500a, 600a.

Referring now to FIG. 4c, sacrificial material has been removed from each of the unfoldable layered connections 400a, 500a, 600a, and the substrate 402 has been divided into separate portions of substrate 466, 566, 666. Hereby, three separate unfoldable layered connections 400a, 500a, 600a is achieved.

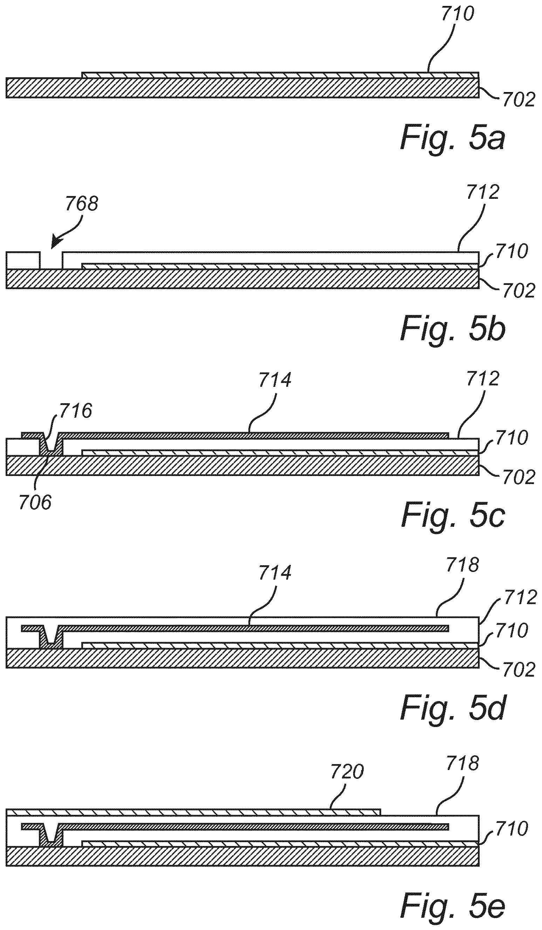

Referring now to FIGS. 5a - 5i, a method for manufacturing an unfoldable layered connection on a substrate according to one aspect of the inventive concept is illustrated. It is to be understood that any of the steps or features disclosed in conjunction with the previous figures may be incorporated into the following aspect.

Referring first to FIG. 5a, a substrate 702 is provided, and a first layer of sacrificial material 710 is provided over the substrate 702. A pattern, shape or form of a first extension referred to below may be determined by the pattern, shape or form of the first layer of sacrificial material 710.

The substrate 702 and the sacrificial material 710 may be provided in one step as illustrated, e.g. the substrate 702 and the sacrificial material 710 may be provided as a pre-fabricated piece in the method according to the inventive concept. It is further envisioned that additional steps of the method according to the inventive concept may be performed in a single step, e.g. may be provided as a pre-fabricated piece. On the contrary, it is also envisioned that the substrate 702 may first be provided, and that the first layer of sacrificial material 710 may subsequently be provided over the substrate 702.

Referring now to FIG. 5b, a first layer of flexible material 712 is provided over the substrate 702 and the first layer of sacrificial material 710, thereby at least partially encapsulating the first layer of sacrificial material 710.

Further, an opening 768 has been provided in the first layer of flexible material 712, thereby exposing at least a portion of the substrate 702. As is readily understood by the person skilled in the art, the opening 768 may be provided by e.g. removing part of the first layer of flexible material 712, and/or via masking when providing the first layer of flexible material 712.

Referring now to FIG. 5c, a first layer of connector material 714 has been provided onto the first layer of flexible material 712 and the substrate 702. The first layer of connector material 714 is in contact with the substrate 702, thereby forming a first contact 706 of connector material and a first node 716 of connector material. The first layer of connector material 714 is at this point considered an uppermost layer of connector material. The first layer of connector material 714 may be patterned to conform to a patterning of the first layer of sacrificial material 710. In other words, the first layer of connector material 714 may have a similar shape as the first layer of sacrificial material 710.

Referring now to FIG. 5d, a second layer of flexible material 718 has been provided over the first layer of connector material 714. In particular, the second layer of flexible material 718 is provided onto the first layer of connector material 714. The second layer of flexible material 718 is in contact with the first layer of flexible material 712, thereby at least partially encapsulating the first layer of connector material 714. At this point, at least a portion of the uppermost layer of connector material may be exposed, thereby forming a second contact of connector material. The first layer of sacrificial material 710 may also be removed in order to create a first void interface between the substrate 702 and the first layer of flexible material 712, thereby forming a first extension across the first void interface. However, in the illustrated example, a second level, i.e. a second extension is created.

Referring now to FIG. 5e, a second layer of sacrificial material 720 has been provided over the second layer of flexible material 718. In particular, the second layer of sacrificial material 720 is provided onto the second layer of flexible material 718. Similarly to the first layer of sacrificial material 710, the second layer of sacrificial material 720, and in particular a patterning of the second layer of sacrificial material 720, may determine a pattern, shape or form of a second extension referred to below.

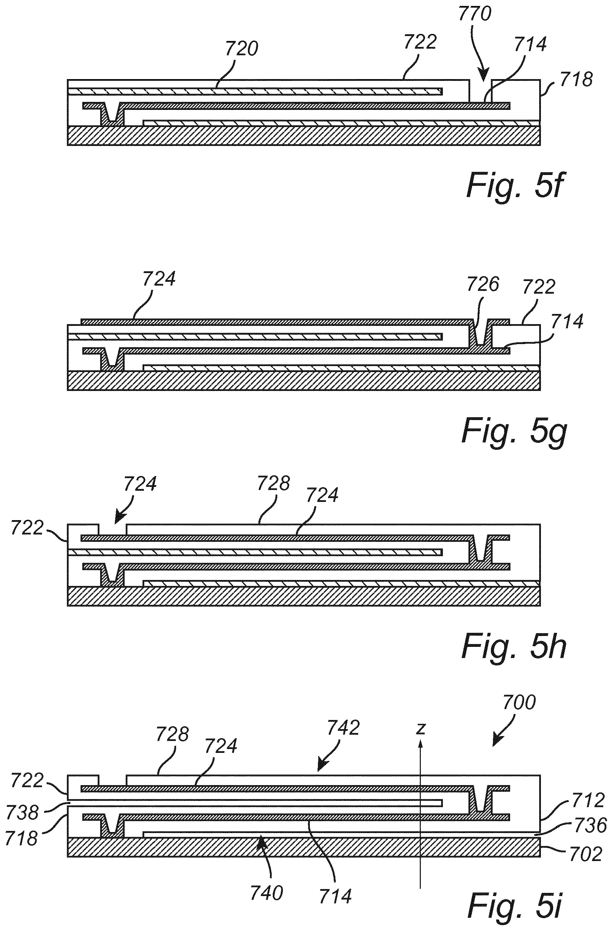

Referring now to FIG. 5f, a third layer of flexible material 722 is provided over the second layer of flexible material 718 and the second layer of sacrificial material 720, thereby at least partially encapsulating the second layer of sacrificial material 720. In particular, the third layer of flexible material 722 is provided onto the second layer of flexible material 718 and the second layer of sacrificial material 720.

Further, a second opening 770 has been provided in the second and third layer of flexible material 718, 722, thereby exposing at least a portion of the first layer of connector material 714. As is readily understood by the person skilled in the art, the second opening 770 may be provided by e.g. removing part of the second and third layer of flexible material 718, 722, and/or via masking when providing the second and third layer of flexible material 718, 722.

Referring now to FIG. 5g, a second layer of connector material 724 has been provided over the third layer of flexible material 722. In particular, the second layer of connector material 724 has been provided onto the third layer of flexible material 722. The second layer of connector material 724 is at this point considered an uppermost layer of connector material. The second layer of connector material 724 is in contact with the first layer of connector material 714, thereby forming a second node of connector material 726.

Referring now to FIG. 5h, a fourth layer of flexible material 728 has been provided over the second layer of connector material 724. In particular, the fourth layer of flexible material 728 has been provided onto the second layer of connector material 724. The fourth layer of flexible material 728 is in contact with the third layer of flexible material 722, thereby at least partially encapsulating the second layer of connector material 724.

Further, at least a portion of the uppermost layer of connector material, in this case the second layer of connector material 724, has been exposed, thereby forming a second contact of connector material 724. This may be achieved by e.g. removing part of the fourth layer of flexible material 728, and/or via masking when providing the fourth layer of flexible material 728.

Referring now to FIG. 5i, the first and second layer of sacrificial material has been removed, thereby creating a first void interface 736 between the substrate 702 and the first layer of flexible material 712, thereby forming a first extension 740 across the first void interface 736 being unfoldable along the z-axis, and further thereby creating a second void interface 738 between the second and third layer of flexible material 718, 722, thereby forming a second extension 742 across the second void interface 738 being unfoldable along the z-axis.

The first extension comprises at least part of the first and second layer of flexible material 712, 718, and the at least partially encapsulated first layer of connector material 714. The second extension comprises at least part of the third and fourth layer of flexible material 722, 728, and the at least partially encapsulated second layer of connector material 724. The resulting device is an unfoldable layered connection 700 comprising a first and a second extension 740, 742.

A method for manufacturing an unfoldable layered connection on a substrate according to one aspect of the inventive concept, wherein the method does not comprise forming the optional base layer of flexible material, will now be described. The advantages and technical features discussed above are equally applicable to this specific aspect.

Such a method may be specified by the steps of:
providing a first layer of connector material over a substrate;
forming the first layer of connector material into a first contact of connector material;
providing a first layer of sacrificial material over the substrate;
providing a first layer of flexible material over the substrate and the first layer of sacrificial material, thereby at least partially encapsulating the first layer of sacrificial material;
removing at least a portion of the first layer of flexible material;
providing a second layer of connector material being an uppermost layer of connector material onto the first layer of flexible material, wherein the second layer of connector material is in contact with the first layer of connector material thereby forming a first node of connector material;
providing a second layer of flexible material onto the second layer of connector material, the second layer of flexible material being in contact with the first layer of flexible material, thereby at least partially encapsulating the second layer of connector material;
exposing at least a portion of the uppermost layer of connector material, thereby forming a second contact of connector material;
removing the first layer of sacrificial material, thereby creating a first void interface between the substrate and the first layer of flexible material, thereby forming a first extension across the first void interface being unfoldable along a z-axis being perpendicular to the substrate;
wherein the first extension comprises at least part of the first and second layer of flexible material, and the at least partially encapsulated second layer of connector material.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

### List of reference signs

- 100: Unfoldable layered connection
- 102: Substrate
- 103: First release layer
- 105: Second release layer
- 106: First contact of connector material
- 108: First layer of flexible material
- 110: First layer of sacrificial material
- 112: Second layer of flexible material
- 114: Second layer of connector material
- 116: First node of connector material
- 118: Third layer of flexible material
- 120: Second layer of sacrificial material
- 122: Fourth layer of flexible material
- 124: Third layer of connector material
- 126: Second node of connector material
- 128: Fifth layer of flexible material
- 130: Access channel
- 132: Neighboring unfoldable layered connection
- 134: Second contact of connector material
- 136: First void interface
- 138: Second void interface
- 200: Unfoldable layered connection
- 200b: Unfoldable layered connection
- 200c: Unfoldable layered connection
- 200d: Unfoldable layered connection
- 216: First node of connector material
- 216c: First node of connector material
- 240: First extension
- 240b: First extension
- 240c: First extension
- 240d: First extension
- 241: Second node of connector material
- 242: Second extension
- 242b: Second extension
- 242c: Second extension
- 242d: Second extension
- 243: Third node of connector material
- 244: Third extension
- 246: Core of connector material
- 248: "
- 250: "
- 253: Structures
- 254c: Sub-extension
- 256c: Sub-extension
- 258c: Sub-extension
- 260c: Sub-extension
- 262c: Node
- 264c: Node
- 300: Unfoldable layered connection
- 302: Substrate
- 316: First node of connector material
- 340: First extension
- 341: Second node of connector material
- 342: Second extension
- 400a: Unfoldable layered connection
- 402: Substrate
- 405: Second release layer
- 466: Separate portion of substrate
- 500a: Unfoldable layered connection
- 505: Second release layer
- 566: Separate portion of substrate
- 600a: Unfoldable layered connection
- 605: Second release layer
- 666: Separate portion of substrate700 Unfoldable layered connection
- 702: Substrate
- 706: First contact of connector material
- 710: First layer of sacrificial material
- 712: First layer of flexible material
- 714: First layer of connector material
- 716: First node of connector material
- 718: Second layer of flexible material
- 720: Second layer of sacrificial material
- 722: Third layer of flexible material
- 724: Second layer of connector material
- 726: Second node of connector material
- 728: Fourth layer of flexible material
- 736: First void interface
- 738: Second void interface
- 740: First extension
- 742: Second extension
- 768: Opening
- 770: Second opening

## Claims

1. A method for manufacturing an unfoldable layered connection (700) on a substrate (702), the method comprising:
providing a substrate (702) with a first layer of sacrificial material (710);
providing a first layer of flexible material (712) over the substrate (702) and the first layer of sacrificial material (710), thereby at least partially encapsulating the first layer of sacrificial material (710);
providing an opening (768) in the first layer of flexible material (712), thereby exposing at least a portion of the substrate (702);
providing a first layer of connector material (714), being an uppermost layer of connector material, over the first layer of flexible material (712) and the substrate (702), wherein the first layer of connector material (714) is in contact with the substrate (702), thereby forming a first contact of connector material and a first node (716) of connector material;
providing a second layer of flexible material (718) over the first layer of connector material (714), the second layer of flexible (718) material being in contact with the first layer of flexible material (712), thereby at least partially encapsulating the first layer of connector material (714);
optionally, exposing at least a portion of the uppermost layer of connector material, thereby forming a second contact of connector material (734);
removing the first layer of sacrificial material (710), thereby creating a first void interface (736) between the substrate (702) and the first layer of flexible material (712), thereby forming a first extension (740) across the first void interface (736) being unfoldable along a z-axis being perpendicular to the substrate (702);
wherein the first extension (740) comprises at least part of the first and second layer of flexible material (712, 718), and the at least partially encapsulated first layer of connector material (714).

2. The method according to claim 1, wherein the step of providing the opening in the first layer of sacrificial material is performed by etching.

3. The method according to any one of the preceding claims, further comprising:
forming at least one access channel arranged to access the first layer of sacrificial material (710);
wherein the step of providing the opening in the first layer of sacrificial material (710) is performed by etching via the at least one access channel.

4. The method according to any one of the preceding claims, comprising, after providing the second layer of flexible material (718), the steps of:
providing a second layer of sacrificial material (720) over the second layer of flexible material (718);
providing a third layer of flexible material (722) over the second layer of flexible material (718) and the second layer of sacrificial material (720), thereby at least partially encapsulating the second layer of sacrificial material (720);
providing a second opening (770) in the second and third layer of flexible material (718, 722), thereby exposing at least a portion of the first layer of connector material (714);
providing a second layer of connector material (724) thereby being the uppermost layer of connector material over the third layer of flexible material (722), wherein the second layer of connector material (724) is in contact with the first layer of connector material (714) thereby forming a second node of connector material (726);
providing a fourth layer of flexible material (728) over the second layer of connector material (724), the fourth layer of flexible material (728) being in contact with the third layer of flexible material (722), thereby at least partially encapsulating the second layer of connector material (724);
removing the second layer of sacrificial material (720) thereby creating a second void interface (738) between the second and third layer of flexible material (718, 722), thereby forming a second extension (742) across the second void (738) interface being unfoldable along the z-axis;
wherein the second extension (742) comprises at least part of the third and fourth layer of flexible material (722, 728), and the at least partially encapsulated second layer of connector material (724).

5. The method according to claim 3 and 4, wherein the at least one access channel is arranged to access the first and second layer of sacrificial material (710, 720), and wherein the step of providing the opening in the first and second layer of sacrificial material (710, 720) is performed by etching via the at least one access channel.

6. The method according to claim 4 or 5, wherein the first and second nodes of connector material (716, 726) are mutually displaced along the z-axis, and wherein the first and second nodes of connector material (716, 726) are connected via connector material.

7. The method according to any one of claims 4 to 6, wherein at least one of the first and second extensions (740, 742) is straight or meander shaped.

8. The method according to according to any one of claims 2 to 7, wherein the etchant is HF.

9. The method according to any one of the preceding claims, wherein the sacrificial material is SiO₂.

10. The method according to any one of the preceding claims, wherein the flexible material is polyimide.

11. The method according to any one of the preceding claims, wherein the first and second layer of flexible material (712, 718) have the same thickness.

12. The method according to any one of the preceding claims, wherein the connector material is an electrically conductive material.

13. The method according to any one of the preceding claims, further comprising the step of providing a base layer of flexible material (708) over the substrate (702) before the step of providing the first layer of sacrificial material (710) over the substrate (702).

14. An unfoldable layered connection (700) comprising:
a substrate (702);
a node of connector material (716, 216) arranged to contact the substrate;
a first extension (740) comprising a core (246) of connector material arranged to be in contact with the node of connector material (716, 216), and flexible material arranged to at least partially enclose the core (246);
wherein the first extension (740) is configured to be hingedly connected to the node of connector material (716, 216), thereby allowing unfolding of the first extension (740) along a z-axis being perpendicular to an extension plane of a major surface of the substrate (702).

15. The unfoldable layered connection according to claim 14, wherein the first extension (740) comprises at least two cores arranged to be in contact with the node of connector material, and wherein the flexible material is arranged to at least partially enclose each core.
